# EUROPEAN PATENT APPLICATION

(11) **EP 4 693 391 A1**
(43) Date of publication of application: **11.02.2026**
(21) Application number: 24779856.4
(22) Date of filing: 21.03.2024
(51) Int. Cl.: H01L 23/14, H01L 23/36, H05K 1/02

(54) **SUBSTRATE FOR MOUNTING SEMICONDUCTOR ELEMENT**

(30) Priority: 30.03.2023 JP 2023055861
(71) Applicant: Niterra Co., Ltd., Nagoya-shi, Aichi 461-0005 (JP)
(72) Inventor: USAMI, Kenzo, Nagoya-shi, Aichi 461-0005 (JP); KONDO, Yosuke, Nagoya-shi, Aichi 461-0005 (JP); MURASE, Tatsunori, Nagoya-shi, Aichi 461-0005 (JP); NISHIMURA, Mitsuru, Nagoya-shi, Aichi 461-0005 (JP); WATANABE, Yukihiro, Nagoya-shi, Aichi 461-0005 (JP); SANO, Isuzu, Nagoya-shi, Aichi 461-0005 (JP)
(74) Representative: Cabinet Beau de Loménie
(86) International application number: PCT/JP2024/011069
(87) International publication number: WO 2024/203736

(57) **Abstract**

A semiconductor element mounting substrate includes a base formed of a metal, an electrode to be connected to a semiconductor element, and a protective layer disposed between the base and the electrode and formed of a material that is more corrosion resistant than the metal forming the base.

## Description

### Technical Field

The present invention relates to a semiconductor element mounting substrate.

### Background Art

Semiconductor element mounting substrates for mounting semiconductor elements are conventionally known. For example, PTL 1 discloses a semiconductor element mounting substrate including a metal-made base, an insulating layer, and an intermediate layer disposed between the base and the insulating layer.

### Citation List

### Patent Literature

PTL 1: Japanese Unexamined Patent Application Publication No. 6-29533

### Summary of Invention

### Technical Problem

However, even with the conventional technology such as that disclosed in PTL 1, there is still room for improvement in the technique for preventing corrosion of the bases of semiconductor element mounting substrates. In the semiconductor element mounting substrate described in PTL 1, the base is formed of a metal. Therefore, when semiconductor elements are mounted on the semiconductor element mounting substrate and used, if salt water adheres to the base, the base may corrode. There is therefore a demand for a technique that can prevent the corrosion of the base.

It is an object of the present invention to provide a technique for preventing corrosion of the base of a semiconductor element mounting substrate.

### Solution to Problem

The present invention has been made to solve at least part of the foregoing problem and can be embodied as the following aspects.

(1) One aspect of the invention provides a semiconductor element mounting substrate. The semiconductor element mounting substrate includes: a base formed of a metal; an electrode to be connected to a semiconductor element; and a protective layer disposed between the base and the electrode and formed of a material that is more corrosion resistant than the metal forming the base.
   In the structure described above, the protective layer disposed between the metal-made base and the electrode is formed of the material that is more corrosion resistant than the metal forming the base. The corrosion of the base can thereby be prevented.
(2) In the semiconductor element mounting substrate in the above aspect, the base may be formed into a flat plate shape, and the protective layer may cover a pair of principal surfaces of the base and a side surface of the base that is formed between the pair of principal surfaces. In the structure described above, the pair of principal surfaces of the base formed into a flat plate shape and its side surface formed between the pair of principal surfaces are covered with the protective layer. In this case, the surface of the base is not exposed to the outside, so that the corrosion of the base can be prevented more effectively.
(3) In the semiconductor element mounting substrate in the above aspect, a thickness of the protective layer may be smaller than a thickness of the base. When the semiconductor element mounting substrate having the structure described above is used as a heat dissipation substrate for dissipating heat generated in the semiconductor element, the corrosion of the base can be prevented without a reduction in heat dissipation performance.
(4) In the semiconductor element mounting substrate in the above aspect, the protective layer may be formed of a metal containing, as a main component, one of nickel, gold, palladium, titanium, molybdenum, tungsten, platinum, silver, lead, and tin. In the structure described above, the metal forming the protective layer and containing, as a main component, one of nickel, gold, palladium, titanium, molybdenum, tungsten, platinum, silver, lead, and tin can be easily formed by plating. Therefore, the protective layer can be relatively easily formed in a process for producing the semiconductor element mounting substrate.
(5) The semiconductor element mounting substrate in the above aspect may further include: an insulating layer disposed between the base and the electrode; and a contact layer that is disposed between the insulating layer and the protective layer and is in close contact with both the insulating layer and the protective layer. In the structure described above, the presence of the contact layer allows the insulating layer and the protective layer to adhere closely to each other. Therefore, while the corrosion of the base is prevented by the protective layer, delamination of the insulating layer from the base can be prevented.
(6) In the semiconductor element mounting substrate in the above aspect, the contact layer may be formed of a metal containing, as a main component, one of titanium, chromium, and molybdenum. In the structure described above, the contact layer formed of the metal containing, as a main component, one of titanium, chromium, and molybdenum is used. Therefore, while the corrosion of the base is prevented by the protective layer, the delamination of the insulating layer from the base can be prevented more effectively.

The present invention can be embodied in various forms. For example, the invention can be embodied as products including the semiconductor element mounting substrate, a method for producing the semiconductor element mounting substrate, etc.

### Brief Description of Drawings

[Fig. 1] Fig. 1 is a schematic cross-sectional view of a semiconductor element mounting substrate in a first embodiment.
[Fig. 2] Fig. 2 is a schematic cross-sectional view of a semiconductor package in the first embodiment.
[Fig. 3] Fig. 3 is a schematic cross-sectional view of a semiconductor element mounting substrate in a second embodiment.
[Fig. 4] Fig. 4 is a cross-sectional view taken along line A-A in Fig. 3.
[Fig. 5] Fig. 5 is a schematic cross-sectional view of a modification of the semiconductor element mounting substrate in the first embodiment.

### Description of Embodiments

### <First embodiment>

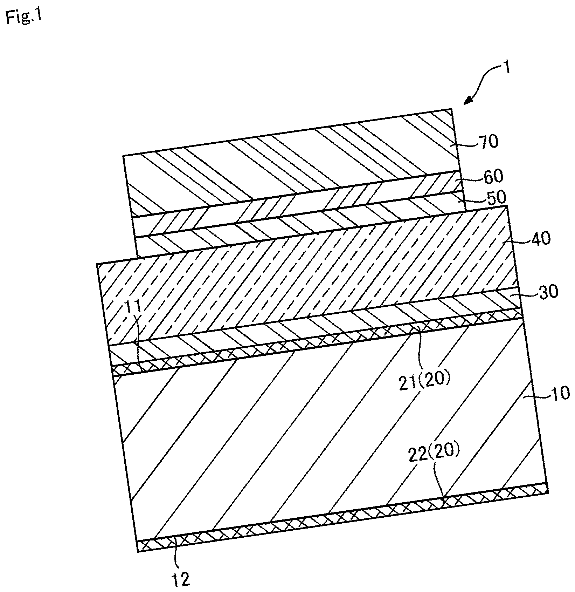

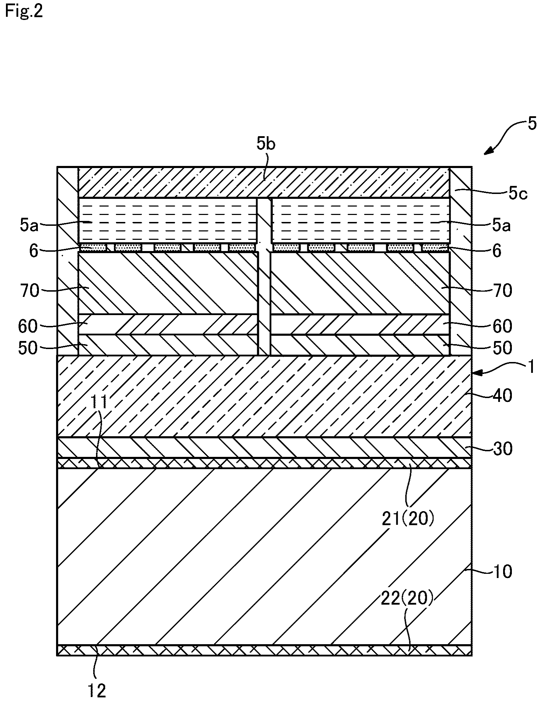

Fig. 1 is a schematic cross-sectional view of a semiconductor element mounting substrate 1 in a first embodiment. Fig. 2 is a schematic cross-sectional view of a semiconductor package 5 in the first embodiment. The semiconductor element mounting substrate 1 in the present embodiment serves as a heat dissipation substrate that supports optical semiconductors such as light emitting diodes (LEDs) or semiconductor lasers (LDs: laser diodes) used as semiconductor elements 5a and that dissipates heat generated during light emission to the outside. The semiconductor element mounting substrate 1 includes a base 10, a protective layer 20, a contact layer 30, an insulating layer 40, a contact layer 50, a bonding layer 60, and an electrode 70. In Figs. 1 and 2, the base 10, the protective layer 20, the contact layer 30, the insulating layer 40, the contact layer 50, the bonding layer 60, the electrode 70, and the semiconductor elements 5a are drawn such that the relations among their thicknesses differ from the actual thickness relations, for the sake of convenience of description.

The base 10 is a member having a flat plate shape and serves as a support of the semiconductor element mounting substrate 1. In the present embodiment, the thickness of the base 10 is 1 mm. The base 10 is formed of a metal. In the present embodiment, the base 10 is formed of copper (Cu). The base 10 may be formed of a material containing copper as a main component, aluminum (Al), or a material containing aluminum as a main component. The term "main component" is a component contained in an amount of more than 50% by mass in the material of interest. The base 10 may be formed of an alloy of copper and aluminum. Since the base 10 is formed of any of these metals, the heat generated in the semiconductor elements 5a can be dissipated to the outside efficiently through the base 10.

The protective layer 20 is formed on each of a pair of principal surfaces 11 and 12 of the base 10. The protective layer 20 includes a protective layer 21 formed on one of the pair of principal surfaces 11 and 12, namely, the principal surface 11, and a protective layer 22 formed on the other principal surface, namely, the principal surface 12. The protective layer 21 is disposed between the base 10 and the electrode 70, more specifically between the base 10 and the contact layer 30.

The protective layer 20 is formed of a material that is more resistant to salt water corrosion than copper forming the base 10. The "resistance to salt water corrosion" refers to the resistance to corrosion in salt water, and the "salt water" refers to water with a sodium chloride (NaCl) concentration of 5% by mass or less. In the present embodiment, the resistance to corrosion in salt water is determined by the value of rest potential in salt water. The rest potential of a material of interest in salt water can be determined by measuring the potential of the material of interest immersed in salt water. Specifically, the rest potentials of gold (Au), palladium (Pd), titanium (Ti), and nickel (Ni) in salt water are higher than the rest potential of copper in salt water. Therefore, the salt water corrosion resistance of each of these metals is higher than that of copper. The protective layer 20 is formed of a metal containing, as a main component, one of nickel, gold, palladium, titanium, molybdenum (Mo), tungsten (W), platinum (Pt), silver (Ag), lead (Pb), and tin (Sn). In the present embodiment, the protective layer 20 is formed of nickel. The protective layer 20 may be formed of a metal containing nickel as a main component or may be formed of a metal containing a nickel-cobalt alloy (Ni-Co), a nickel-phosphorus alloy (Ni-P), or a nickel-boron alloy (Ni-B).

The rest potential of nickel forming the protective layer 20 in an iodine-potassium iodide solution used to etch the bonding layer 60 and the electrode 70 described later is higher than that of copper. Specifically, the corrosion resistance of the protective layer 20 in the iodine-potassium iodide solution is higher than that of copper. Moreover, the rest potential of nickel forming the protective layer 20 in aqueous hydrogen peroxide used to etch the contact layers 30 and 50 described later is higher than that of copper. Specifically, the corrosion resistance of the protective layer 20 in aqueous hydrogen peroxide is higher than that of copper. As described above, the corrosion resistance of the protective layer 20 formed of nickel in salt water, its corrosion resistance in the iodine-potassium iodide solution, and its corrosion resistance in aqueous hydrogen peroxide are higher than those of copper.

The thickness of each of the protective layers 21 and 22 included in the protective layer 20 is smaller than the thickness of the base 10. In the present embodiment, the thickness of each of the protective layers 21 and 22 is, for example, 3 micrometers. In this case, when the semiconductor element mounting substrate 1 is used as a heat dissipation substrate for the semiconductor elements 5a, it is unlikely that the protective layers 21 and 22 serve as heat dissipation resistance.

The contact layer 30 is disposed between the protective layer 20 and the insulating layer 40. The contact layer 30 is formed of a metal containing, as a main component, any one of titanium, chromium (Cr), and molybdenum. In the present embodiment, the contact layer 30 is formed of a metal containing titanium as a main component such as titanium or titanium oxide (TiO₂). The thickness of the contact layer 30 is, for example, 0.5 micrometers. The contact layer 30 is in close contact with both the protective layer 20 and the insulating layer 40 and prevents the formation of cracks in the insulating layer 40 due to the difference in thermal expansion coefficient.

The insulating layer 40 is disposed between the base 10 and the electrode 70, more specifically between the contact layer 30 and the contact layer 50. The insulating layer 40 is formed of alumina (Al₂O₃). In the present embodiment, the thickness of the insulating layer 40 is 50 micrometers or less. The insulating layer 40 provides insulation between the metal-made base 10 and the electrode 70. The material of the insulating layer 40 is not limited to alumina, and the insulating layer 40 may be formed of a ceramic material such as silicon nitride (SiNx), aluminum nitride (AlN), aluminum oxynitride (AlON), silicon oxynitride (SiON), yttrium oxide (Y₂O₃), silicon carbide (SiC), silicon dioxide (SiO₂), SiOCN, or SiBCN.

The contact layer 50 is disposed between the insulating layer 40 and the bonding layer 60. In the present embodiment, the contact layer 50 is formed of a metal containing titanium as a main component such as titanium or titanium oxide (TiO₂). The thickness of the contact layer 50 is, for example, 0.2 micrometers. The contact layer 50 is in close contact with both the insulating layer 40 and the bonding layer 60 and prevents the formation of cracks in the insulating layer 40 due to the difference in thermal expansion coefficient.

The bonding layer 60 is disposed between the contact layer 50 and the electrode 70. The bonding layer 60 is formed of palladium and has a thickness of, for example, 0.07 micrometers. The bonding layer 60 increases the bonding strength between the contact layer 50 and the electrode 70.

The electrode 70 is to be connected to the semiconductor elements 5a via bumps 6 (see Fig. 2). The electrode 70 is formed of gold (Au) and has a thickness of, for example, 3.0 micrometers.

The semiconductor package 5 includes the semiconductor element mounting substrate 1, the semiconductor elements 5a, a phosphor 5b, and a resin portion 5c (see Fig. 2). In the semiconductor package 5, the phosphor 5b is disposed on the semiconductor elements 5a connected to the semiconductor element mounting substrate 1 via the bumps 6 and is located on the side opposite from the semiconductor element mounting substrate 1. The phosphor 5b converts the wavelength of light emitted from the semiconductor elements 5a serving as optical semiconductors, and the converted light is emitted to the outside. The resin portion 5c seals the semiconductor elements 5a and the phosphor 5b.

Next, a method for producing the semiconductor element mounting substrate 1 in the present embodiment will be described. First, a nickel layer is deposited on each of a pair of principal surfaces of a copper-made flat plate member used as the base 10 by plating, sputtering, etc. After the deposition of the nickel layer, a titanium layer corresponding to the contact layer 30, an alumina layer corresponding to the insulating layer 40, a titanium layer corresponding to the contact layer 50, a palladium layer corresponding to the bonding layer 60, and a gold layer corresponding to the electrode 70 are deposited in this order on the nickel layer. After the deposition of the metal layers including the gold layer on the nickel layer, the metal layers including the gold layer are etched into a prescribed pattern, and the flat plate member is cut to produce the semiconductor element mounting substrate 1.

Next, the features of the semiconductor element mounting substrate 1 in the present embodiment will be described in relation to problems with a semiconductor element mounting substrate in a comparative example that does not have a structure corresponding to the protective layer 20 in the present embodiment. When, for example, the semiconductor element mounting substrate is used as a heat dissipation substrate for a semiconductor element, copper having relatively high heat dissipation performance is used as the material of the base. However, the corrosion resistance of copper is relatively low. Therefore, in the semiconductor element mounting substrate in the comparative example that does not have the structure corresponding to the protective layer 20 in the present embodiment, the base may corrode when, for example, salt water adheres to the base in an environment in which salt water is present.

In the semiconductor element mounting substrate 1 in the present embodiment, the protective layer 20 formed on the pair of principal surfaces 11 and 12 of the base 10 is formed of nickel. The rest potential of nickel in salt water is higher than that of copper forming the base 10, and the salt water corrosion resistance of nickel is higher than that of copper. Therefore, even when the semiconductor package 5 including the semiconductor element mounting substrate 1 is actually used in an environment in which salt water is present, the corrosion of the base 10 can be prevented. In this case, the occurrence of problems in actual use can be reduced.

Generally, in a semiconductor element mounting substrate production process, a plurality of layers are deposited on the base, and etching is performed to form a prescribed pattern, as described above. However, the corrosion resistance of copper forming the base is relatively low. Therefore, in the semiconductor element mounting substrate in the comparative example, the base may undergo galvanic corrosion by an iodine-potassium iodide solution etc. used for the etching. The corrosion of the base not only makes it difficult for the base to support the semiconductor elements but also causes a reduction in the adhesion between the base and the resin in the semiconductor package in which the semiconductor elements are sealed by the resin, so that the semiconductor elements cannot be sealed. Moreover, a lot of time and effort is required to prevent the corrosion of the base during etching, and the production cost thereby increases.

However, the semiconductor element mounting substrate 1 in the present embodiment includes the protective layer 20 disposed between the base 10 and the electrode 70 and formed of nickel, which is more resistant to corrosion in the iodine-potassium iodide solution and aqueous hydrogen peroxide than copper forming the base 10. In this case, the base 10 is prevented from corrosion by the iodine-potassium iodide solution and aqueous hydrogen peroxide during the process of producing the semiconductor element mounting substrate 1, so that the semiconductor elements 5a can be sealed in the semiconductor package 5 while supported by the base 10. Since the corrosion of the base 10 is prevented, there is no need to protect the base 10 in the process of producing the semiconductor element mounting substrate 1, and the production cost can thereby be reduced. Moreover, in the semiconductor element mounting substrate 1 in the present embodiment, the surface of the copper-made base 10 serving as a support is covered with nickel forming the protective layer 20 and thereby hardened. In this case, the base 10 is prevented from being scratched during handling when the semiconductor element mounting substrate 1 is produced. Since the surface of the base 10 is prevented from being scratched, the process control such as the control of the surface roughness of the base 10 is facilitated.

When the base included in the semiconductor element mounting substrate in the comparative example is formed of nickel, the insulating layer may be delaminated from the base because the adhesion between the nickel and alumina forming the insulating layer is low. In the semiconductor element mounting substrate 1 in the present embodiment, the contact layer 30 formed of a metal containing titanium as a main component is disposed between the insulating layer 40 and the protective layer 20. The contact layer 30 is in close contact with both the protective layer 20 and the insulating layer 40, so that delamination of the insulating layer 40 from the base 10 can be prevented. Therefore, the occurrence of a short circuit between the copper-made base 10 and the electrode 70 can be prevented.

In the above-described semiconductor element mounting substrate 1 in the present embodiment, the protective layer 20 disposed between the base 10 and the electrode 70 is formed of nickel, which is more resistant to salt water corrosion than copper forming the base 10. Therefore, the corrosion of the base 10 due to adhesion of salt water during actual use can be prevented.

In the semiconductor element mounting substrate 1 in the present embodiment, the corrosion resistance of nickel forming the protective layer 20 in the iodine-potassium iodide solution and aqueous hydrogen peroxide that are used to produce the semiconductor element mounting substrate 1 is higher than that of copper forming the base 10. In this case, the corrosion of the base 10 during etching when the semiconductor element mounting substrate 1 is produced can be prevented.

In the semiconductor element mounting substrate 1 in the present embodiment, the thickness of the protective layer 20 is smaller than the thickness of the base 10. In this case, the corrosion of the base 10 can be prevented while the protective layer 20 does not cause a reduction in the heat dissipation performance of the semiconductor element mounting substrate 1.

In the semiconductor element mounting substrate 1 in the present embodiment, the nickel forming the protective layer 20 can be easily formed by plating. Therefore, the protective layer 20 can be relatively easily formed in the process of forming the semiconductor element mounting substrate 1.

In the semiconductor element mounting substrate 1 in the present embodiment, the contact layer 30 allows the insulating layer 40 and the protective layer 20 to adhere closely to each other. Therefore, while the protective layer 20 prevents the corrosion of the base 10, the delamination of the insulating layer 40 from the base 10 can be prevented.

In the semiconductor element mounting substrate 1 in the present embodiment, the contact layer 30 formed of titanium is used. In this case, while the protective layer 20 prevents the corrosion of the base 10, the delamination of the insulating layer 40 from the base 10 can be prevented more effectively.

### <Second embodiment>

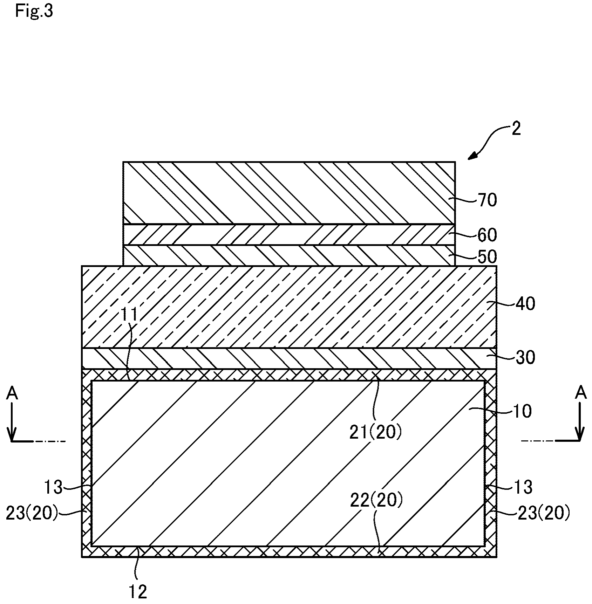

Fig. 3 is a cross-sectional view of a semiconductor element mounting substrate 2 in a second embodiment. The semiconductor element mounting substrate 2 in the second embodiment differs from the semiconductor element mounting substrate 1 in the first embodiment (Fig. 1) in the locations of the protective layer disposed on the base.

The semiconductor element mounting substrate 2 in the second embodiment includes a base 10, a protective layer 20, a contact layer 30, an insulating layer 40, a contact layer 50, a bonding layer 60, an electrode 70, and a protective layer 80. In Fig. 3, the base 10, the protective layer 20, the contact layer 30, the insulating layer 40, the contact layer 50, the bonding layer 60, the electrode 70, and the protective layer 80 are drawn such that the relations among their thicknesses differ from the actual thickness relations, for the sake of convenience of description.

The protective layer 20 covers a pair of principal surfaces 11 and 12 of the base 10 and side surfaces 13 formed between the pair of principal surfaces 11 and 12. The protective layer 20 included in the semiconductor element mounting substrate 2 includes a protective layer 21 formed on one of the pair of principal surfaces 11 and 12, namely, the principal surface 11, a protective layer 22 formed on the other principal surface, namely, the principal surface 12, and a protective layer 23 formed on the side surfaces 13. As shown in Fig. 3, the protective layer 23 is formed so as to be connected to the protective layer 21 and the protective layer 22. The thickness of the protective layer 23 is smaller than the thickness of the base 10.

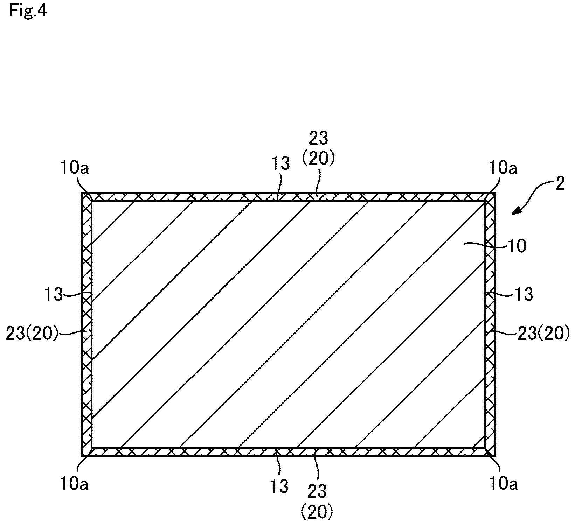

Fig. 4 is a cross-sectional view taken along line A-A in Fig. 3 and is a cross-sectional view of the base 10 and the protective layer 23. The protective layer 23 is formed on each of the four side surfaces 13 of the base 10 whose cross section perpendicular to the stacking direction of the layers of the semiconductor element mounting substrate 1 has a rectangular shape. In the present embodiment, the four faces of the protective layer 23 are connected to each other at four edges 10a of the base 10, as shown in Fig. 4. Specifically, the protective layer 23 is formed so as to cover the entire side surfaces 13 of the base 10. In this case, the protective layer 20 covers the entire surface of the base 10.

In the above-described semiconductor element mounting substrate 2 in the present embodiment, the protective layer 20 disposed between the base 10 and the electrode 70 is formed of nickel, which is more resistant to salt water corrosion than copper forming the base 10. Therefore, the corrosion of the base 10 due to adhesion of salt water can be prevented.

In the semiconductor element mounting substrate 2 in the present embodiment, the pair of principal surfaces 11 and 12 of the base 10 formed into a flat plate shape and the side surfaces 13 formed between the pair of principal surfaces 11 and 12 are covered with the protective layer 20. Therefore, the surface of the base 10 is not exposed to the outside, so the corrosion of the base 10 can be prevented more effectively.

### <Modifications of embodiments>

The present invention is not limited to the embodiments described above and can be embodied in various other forms without departing from the scope of the invention. For example, the following modifications are possible.

### [Modification 1]

In the embodiments described above, the semiconductor element mounting substrate supports the optical semiconductors and serves as a heat dissipation substrate that dissipates the heat generated during light emission. However, the semiconductors mounted on the semiconductor element mounting substrate are not limited to the optical semiconductors.

### [Modification 2]

In the embodiments described above, the protective layer 20 is formed of nickel, which is more resistant to corrosion in salt water, the iodine-potassium iodide solution, and aqueous hydrogen peroxide than copper forming the base 10. However, the liquid used to evaluate the corrosion resistance of the protective layer 20 is not limited to these liquids. For example, the protective layer may be formed of a material that is more corrosion resistant than copper only in the iodine-potassium iodide solution or may be formed of a material that is more corrosion resistant than the material forming the base only in aqueous hydrogen peroxide. Specifically, gold, palladium, titanium, etc., whose rest potentials in the iodine-potassium iodide solution are higher than that of copper, may be used, and gold, palladium, etc., whose rest potentials in aqueous hydrogen peroxide are higher than that of copper, may be used. As described above, gold and palladium are more resistant to salt water corrosion than copper. Therefore, when gold or palladium is used to form the protective layer, corrosion due to adhesion of salt water during actual use and corrosion during etching when the semiconductor element mounting substrate 1 is produced can be prevented, as with the protective layer 20 in the embodiments described above. The rest potential of the material of interest in the iodine-potassium iodide solution or aqueous hydrogen peroxide can be determined by measuring the potential of the material of interest immersed in the iodine-potassium iodide solution or aqueous hydrogen peroxide.

### [Modification 3]

In the first embodiment, the protective layer 20 is formed on each of the pair of principal surfaces 11 and 12 of the base 10. In the second embodiment, the protective layer 20 covers the pair of principal surfaces 11 and 12 of the base 10 and the side surfaces 13 formed between the pair of principal surfaces 11 and 12. However, the locations of the protective layer 20 formed on the base 10 are not limited to the above locations. It is only necessary that at least part of the protective layer 20 be disposed between the base 10 and the electrode 70.

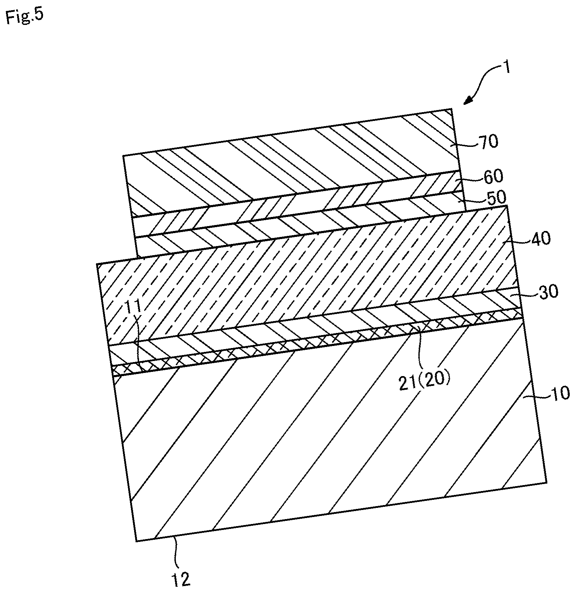

Fig. 5 is a schematic cross-sectional view of a modification of the semiconductor element mounting substrate 1 in the first embodiment. In the modification of the semiconductor element mounting substrate 1 shown in Fig. 5, the protective layer 20 includes only the protective layer 21 formed on the principal surface 11 on the side on which the insulating layer 40 and the electrode 70 are formed. Even with the semiconductor element mounting substrate 1 shown in Fig. 5, the corrosion of the base 10 by salt water can be prevented.

### [Modification 4]

In the embodiments described above, the thickness of each of the protective layers 21, 22, and 23 included in the protective layer 20 is smaller than the thickness of the base 10. The thickness of each of the protective layers 21, 22, and 23 may be larger than or equal to the thickness of the base 10. When the thickness of each of the protective layers 21, 22, and 23 is smaller than the thickness of the base 10, it is unlikely that, when the semiconductor element mounting substrate 1 is used as a heat dissipation substrate for the semiconductor elements 5a, the protective layers 21, 22, and 23 serve as heat dissipation resistance, so that a reduction in the heat dissipation efficiency of the semiconductor element mounting substrate 1 can be prevented.

### [Modification 5]

In the embodiments described above, the protective layer 20 is formed of nickel. However, the material forming the protective layer 20 is not limited to nickel. The protective layer 20 may be formed of a metal containing, as a main component, at least one of nickel, gold, palladium, titanium, molybdenum, tungsten, platinum, silver, lead, and tin. The protective layer 20 may be formed of a metal containing a nickel-cobalt alloy (Ni-Co), a nickel-phosphorus alloy (Ni-P), or a nickel-boron alloy (Ni-B). It is only necessary that the protective layer 20 be formed of a material that is more corrosion resistant than the metal forming the base 10.

### [Modification 6]

In the embodiments described above, the base 10 is formed of copper. However, the material forming the base 10 is not limited to copper. When the semiconductor element mounting substrate is used as a heat dissipation substrate for dissipating the heat generated in the semiconductor elements, it is desirable to use a metal having relatively high thermal conductivity, but the material is not limited to metals.

### [Modification 7]

In the embodiments described above, the semiconductor element mounting substrate includes the contact layer 30 that allows the insulating layer 40 and the protective layer 20 to adhere closely to each other. However, it is not always necessary to provide the contact layer. By providing the contact layer 30 between the insulating layer 40 and the protective layer 20, delamination of the insulating layer 40 from the base 10 can be prevented. The material forming the contact layer 30 is not limited to the metal containing titanium as a main component. The material forming the contact layer 30 may be a metal containing chromium or molybdenum as a main component. It is only necessary that the material used can adhere closely to both the protective layer 20 and the insulating layer 40.

Although the aspects of the invention have been described based on the embodiments and modifications, the above-described embodiments of the aspects of the invention are provided so as to facilitate the understanding of the aspects and do not limit the aspects. The aspects of the invention can be changed or improved without departing from the gist of the aspects and the scope of the claims and encompass equivalents thereof. Some of the technical features of the aspects of the invention may be appropriately eliminated unless they are described as essential features in the present specification.

### (Application Example 1)

A semiconductor element mounting substrate including:
a base formed of a metal;
an electrode to be connected to a semiconductor element; and
a protective layer disposed between the base and the electrode and formed of a material that is more corrosion resistant than the metal forming the base.

### (Application Example 2)

The semiconductor element mounting substrate in accordance with Application Example 1, wherein the base is formed into a flat plate shape, and
wherein the protective layer covers a pair of principal surfaces of the base and a side surface of the base that is formed between the pair of principal surfaces.

### (Application Example 3)

The semiconductor element mounting substrate in accordance with Application Example 1 or 2, wherein a thickness of the protective layer is smaller than a thickness of the base.

### (Application Example 4)

The semiconductor element mounting substrate in accordance with any one of Application Examples 1 to 3, wherein the protective layer is formed of a metal containing, as a main component, one of nickel, gold, palladium, titanium, molybdenum, tungsten, platinum, silver, lead, and tin.

### (Application Example 5)

The semiconductor element mounting substrate in accordance with any one of Application Examples 1 to 4, further including:
an insulating layer disposed between the base and the electrode; and
a contact layer that is disposed between the insulating layer and the protective layer and is in close contact with both the insulating layer and the protective layer.

### (Application Example 6)

The semiconductor element mounting substrate in accordance with any one of Application Examples 1 to 5, wherein the contact layer is formed of a metal containing, as a main component, one of titanium, chromium, and molybdenum.

### Reference Signs List

1, 2 semiconductor element mounting substrate
5a semiconductor element
10 base
11, 12 principal surface
13 side surface
20, 21 protective layer
30 contact layer
40 insulating layer
70 electrode

## Claims

1. A semiconductor element mounting substrate comprising:
a base formed of a metal;
an electrode to be connected to a semiconductor element ; and
a protective layer disposed between the base and the electrode and formed of a material that is more corrosion resistant than the metal forming the base.

2. The semiconductor element mounting substrate in accordance with claim 1, wherein the base is formed into a flat plate shape, and
wherein the protective layer covers a pair of principal surfaces of the base and a side surface of the base that is formed between the pair of principal surfaces.

3. The semiconductor element mounting substrate in accordance with claim 1 or 2, wherein a thickness of the protective layer is smaller than a thickness of the base.

4. The semiconductor element mounting substrate in accordance with claim 1 or 2, wherein the protective layer is formed of a metal containing, as a main component, one of nickel, gold, palladium, titanium, molybdenum, tungsten, platinum, silver, lead, and tin.

5. The semiconductor element mounting substrate in accordance with claim 1 or 2, further comprising:
an insulating layer disposed between the base and the electrode; and
a contact layer that is disposed between the insulating layer and the protective layer and is in close contact with both the insulating layer and the protective layer.

6. The semiconductor element mounting substrate in accordance with claim 5, wherein the contact layer is formed of a metal containing, as a main component, one of titanium, chromium, and molybdenum.
